# EUROPEAN PATENT SPECIFICATION

(11) **EP 4 567 448 B1**
(45) Date of publication and mention of the grant of the patent: **25.11.2026**
(21) Application number: 23872841.4
(22) Date of filing: 06.09.2023
(51) Int. Cl.: G01R 31/396, G01R 31/3835, G01R 19/10, G01R 31/374, G01R 31/392

(54) **BATTERY MANAGEMENT SYSTEM, BATTERY MANAGEMENT METHOD, AND BATTERY PACK INCLUDING THE SYSTEM**
BATTERIEMANAGEMENTSYSTEM, BATTERIEMANAGEMENTVERFAHREN UND BATTERIEPACK MIT DEM SYSTEM
SYSTÈME DE GESTION DE BATTERIE, PROCÉDÉ DE GESTION DE BATTERIE ET BLOC-BATTERIE COMPRENANT CE SYSTÈME

(30) Priority: 30.09.2022 KR 20220125848
(43) Date of publication of application: 11.06.2025
(73) Proprietor: LG Energy Solution, Ltd., Seoul 07335 (KR)
(72) Inventor: LIM, Sung Chul, Daejeon 34122 (KR); HUH, Geun Hoe, Daejeon 34122 (KR); KWAK, Seo Young, Daejeon 34122 (KR)
(74) Representative: Plasseraud IP
(86) International application number: PCT/KR2023/013372
(87) International publication number: WO 2024/071721

(56) References cited:
- CN-A- 113 904 005
- KR-A- 20100 075 913
- KR-A- 20150 060 373
- KR-A- 20210 040 423
- KR-A- 20210 106 164
- KR-A- 20220 006 474
- KR-B1- 101 610 908
- KR-B1- 101 610 908
- US-A1- 2009 104 510

## Description

### TECHNICAL FIELD

### CROSS-REFERENCE TO RELATED APPLICATION

The present application claims the benefit of the priority of Korean Patent Application No. 10-2022-0125848, filed on September 30, 2022.

### TECHNICAL FIELD

The present invention relates to a system and method for managing a battery, and a battery pack including the system, and more particularly, to a system and method for managing a battery, capable of accurately measuring characteristics of a battery cell, and a battery pack including the system.

### BACKGROUND ART

Recently, as a demand for portable electronic products such as notebook computers, video cameras, and mobile phones rapidly increases, and development for electric vehicles, accumulators for energy storage, robots, and satellites is regularized, much research is carried out on secondary batteries used as driving power sources thereof.

Secondary batteries are used as a battery pack including a battery module in which a plurality of battery cells are connected to each other in series and/or parallel. States and operations of the battery pack are managed and controlled by a battery management system.

The battery management system may measure electrical characteristics of the battery cells, and determine a state of the battery based on the measured characteristics. However, when the electrical characteristics of the battery cells are not accurately measured, the state of the battery may not be properly checked. Known examples of battery management systems can be found in KR 2021 0106164 A, US 2009/104510 A1, CN 113 904 005 A and KR 101 610 908 B1.

### DISCLOSURE OF THE INVENTION

### TECHNICAL PROBLEM

Embodiments according to the present invention provide a system and method for managing a battery, capable of accurately measuring characteristics of a battery cell, and a battery pack including the system.

The technical problems of the present invention are not limited to the aforementioned technical problems, and the other technical problems not mentioned above could be clearly understood by those skilled in the art from the disclosure below.

### TECHNICAL SOLUTION

The invention is defined by the battery pack according to claim 1, the battery management system according to claim 7 and the battery management method according to claim 9. Further aspects are defined by the corresponding dependent claims.

### ADVANTAGEOUS EFFECTS

According to the present invention, the electrical characteristics (e.g., the negative electrode voltage and the cell voltage) of the battery cell may be accurately measured through the reference electrode included in the reference cell.

According to the present invention, the state of health of the battery cell may be accurately measured based on the at least one of the negative electrode voltage or the cell voltage.

According to the present invention, as the state of health of the battery cell may be accurately measured, the cell balancing may be performed.

In addition, the various effects directly or indirectly found through this document may be provided.

### BRIEF DESCRIPTION OF THE DRAWINGS

FIG. 1 is a block diagram illustrating a battery pack according to the present invention.
FIG. 2 is a perspective view illustrating a battery cell included in a battery module illustrated in FIG. 1.
FIG. 3 is a plan view illustrating a reference cell included in the battery pack illustrated in FIG. 1.
FIG. 4 is a detailed block diagram illustrating a battery management system illustrated in FIG. 1.
FIG. 5 is a flowchart illustrating a battery management method according to a first embodiment of the present invention.
FIG. 6 is a graph illustrating a negative electrode voltage according to a change in state of charge (SOC) of each of a battery cell and a reference cell according to the first embodiment of the present invention.
FIG. 7 is a flowchart illustrating a battery management method according to a second embodiment of the present invention.
FIG. 8 is a graph illustrating a negative electrode voltage according to a change in SOC of each of a battery cell and a reference cell according to the second embodiment of the present invention.

### MODE FOR CARRYING OUT THE INVENTION

Hereinafter, preferred embodiments of the present invention will be described in detail with reference to the accompanying drawings to enable those skilled in the art to which the present invention pertains to easily carry out the present invention. The present invention may, however, be embodied in different forms and should not be construed as limited by the embodiments set forth herein.

The parts unrelated to the description, or the detailed descriptions of related well-known art that may unnecessarily obscure subject matters of the present invention, will be ruled out in order to clearly describe the present invention. Like reference numerals refer to like elements throughout the whole specification.

Moreover, terms or words used in this specification and claims should not be restrictively interpreted as ordinary meanings or dictionary-based meanings, but should be interpreted as meanings and concepts conforming to the scope of the present invention on the basis of the principle that an inventor can properly define the concept of a term to describe and explain his or her invention in the best ways.

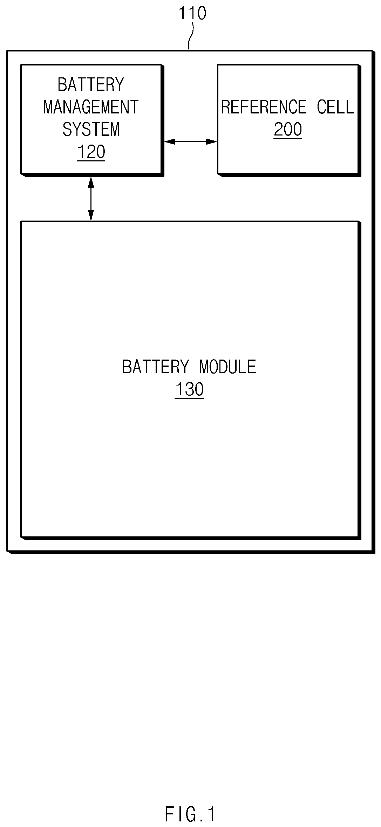

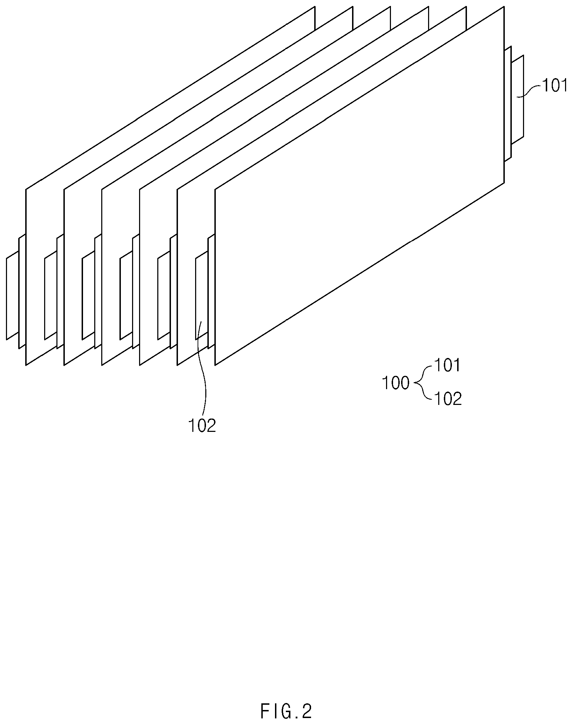

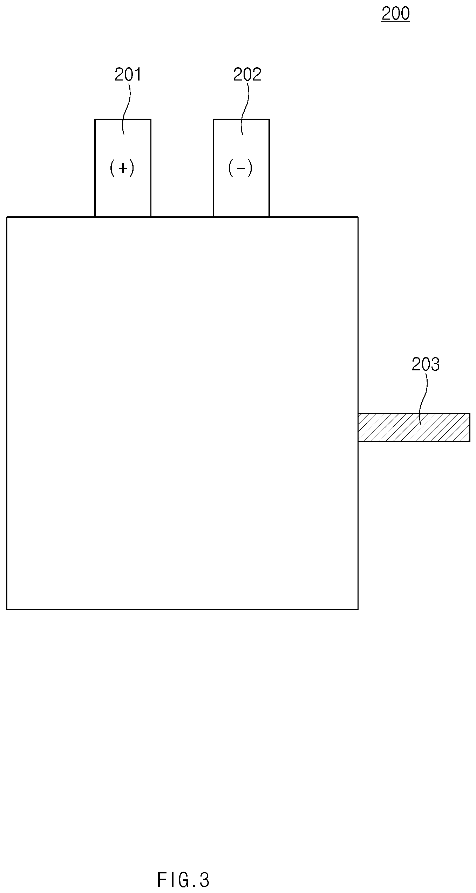

FIG. 1 is a block diagram illustrating a battery pack according to the present invention. FIG. 2 is a perspective view illustrating a battery cell included in a battery module illustrated in FIG. 1. FIG. 3 is a plan view illustrating a reference cell included in the battery pack illustrated in FIG. 1.

Referring to FIGS. 1 to 3, a battery pack 110 may include a reference cell 200, a battery module 130, and a battery management system 120.

The battery module 130 may be provided in plurality, and each of the plurality of battery modules 130 may be provided in the form of a stack in which a plurality of battery cells 100 are stacked. As illustrated in FIG. 2, each of the plurality of battery cells 100 may have a two-electrode structure including a first positive electrode 101 (or working electrode) and a first negative electrode 102 (or counter electrode).

The reference cell 200 may be provided in at least one. The reference cell 200 may include more electrodes than the battery cell 100. The reference cell 200 may have a three-electrode structure including a second positive electrode 201, a second negative electrode 202, and a reference electrode 203.

The reference electrode 203 may be used as a potential standard when measuring a relative value of an electrode potential. As current flows between the second positive electrode 201 and the second negative electrode 202, and the current hardly flows through the reference electrode 203, potential of the reference electrode 203 itself may not change. When measuring a second negative electrode voltage corresponding to a difference in potential between the reference electrode 203 and the second negative electrode 202 of the reference cell 200, the second negative electrode voltage may be precisely measured because the potential of the reference electrode 203 does not change. When measuring a second positive electrode voltage corresponding to a difference in potential between the reference electrode 203 and the second positive electrode 201 of the reference cell 200, the second positive electrode voltage may be precisely measured because the potential of the reference electrode 203 itself does not change.

The battery management system 120 may include a plurality of terminals as interfaces that receive values obtained by measuring various parameters, a circuit connected to these terminals to perform processing of the received values, and the like.

The battery management system 120 may monitor voltages, current, temperatures, or the like of each of the battery cell 100 included in the battery module 130 and the reference cell 200, to manage and control the battery cells so as to prevent overcharge, overdischarge, and the like, of the battery cell 100.

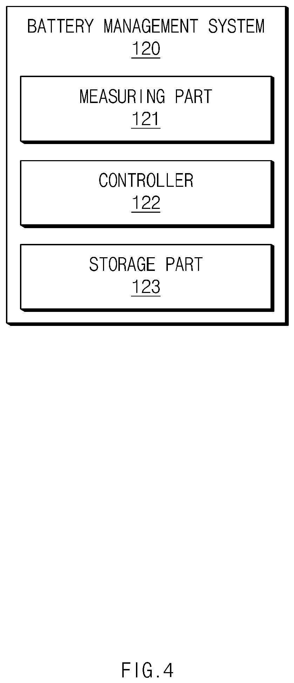

FIG. 4 is a detailed block diagram illustrating the battery management system illustrated in FIG. 1.

Referring to FIG. 4, the battery management system 120 may include a measuring part 121, a controller 122, and a storage part 123.

The measuring part 121 may measure a first voltage of a battery cell (e.g., the battery cell 100 in FIG. 2), and measure a second voltage of a reference cell (e.g., the reference cell 200 in FIG. 3).

The measuring part 121 may measure a first negative electrode voltage (or first voltage) of the battery cell while charging the battery cell. The measuring part 121 may measure the first negative electrode voltage corresponding to a difference between potential of a first negative electrode of the battery cell and reference potential (e.g., 0 V). The measuring part 121 may measure a second negative electrode voltage (or second voltage) corresponding to a difference in potential between a reference electrode and a second negative electrode of the reference cell while charging the reference cell.

The measuring part 121 may measure the first negative electrode voltage in an opened state of the battery cell, and measure the second negative electrode voltage in an opened state of the reference cell.

The controller 122 may be configured to calculate a deviation between the first negative electrode voltage of the battery cell and the second negative electrode voltage of the reference cell. The controller 122 may be communicatively connected to the measuring part 121 in a wired and/or wireless manner. The controller 122 may receive the first negative electrode voltage and the second negative electrode voltage from the measuring part 121, and calculate a voltage deviation between the received first negative electrode voltage and second negative electrode voltage.

As one example, the controller 122 may accurately correct the first negative electrode voltage based on the voltage deviation between the first negative electrode voltage and the second negative electrode voltage. As first positive electrode potential is changed in a state in which current flows between the first positive electrode and the first negative electrode of the battery cell, first negative electrode potential may be also changed, and thus the first negative electrode voltage is difficult to accurately measure. In contrast, in the reference cell including the reference electrode, the second negative electrode voltage may be accurately measured compared to the battery cell. Accordingly, the controller 122 may accurately calculate the first negative electrode voltage by correcting the first negative electrode voltage based on the deviation between the first negative electrode voltage and the second negative electrode voltage, which are measured through the measuring part. The controller 122 may estimate a state of health (SOH) of each of the battery module and the battery pack, which include the battery cell, based on the corrected first negative electrode voltage. The controller 122 may estimate the SOH of each of the battery module and the battery pack based on data of a correlation between a pre-measured first negative electrode voltage and SOH. Data of a correlation between a corrected first negative electrode voltage and SOH may be pre-stored in the storage part 123. The data of the correlation between the corrected first negative electrode voltage and the SOH may be values obtained in advance through at least one pre-estimation. In the storage part 123, the data of the correlation between the corrected first negative electrode voltage and the SOH may be re-estimated at fixed intervals and periodically updated.

As another example, the controller 122 may estimate a state of health (SOH) of each of the battery module and the battery pack, which include the battery cell, based on the voltage deviation between the first negative electrode voltage and the second negative electrode voltage. The controller 122 may estimate the SOH of each of the battery module and the battery pack based on data of a correlation between a voltage deviation between pre-measured negative electrode voltages and SOH. The data of a correlation between a voltage deviation between negative electrode voltages of the battery cell and the reference cell and SOH may be pre-stored in the storage part 123. The data of the correlation between the deviation between the negative electrode voltages of the battery cell and the reference cell and the SOH may be values obtained in advance through at least one pre-estimation. In the storage part 123, the data of the correlation between the deviation between negative electrode voltages of the battery cell and the reference cell and the SOH may be re-estimated at fixed intervals and periodically updated.

The controller 122 may determine a state of each of the battery module and the battery pack, which include the battery cell, based on the estimated SOH. The controller 122 may predict a degree of degradation, replacement time, lifetime, and the like of the battery cell based on the estimated SOH. In addition, the controller 122 may select a battery cell, which is subject to balancing, based on the SOH of each of the plurality of battery cells. For example, the controller 122 may compare the respective SOHs of the plurality of battery cells, and select, as an object to be balanced, a battery cell of which the SOH goes beyond a threshold. The controller 122 may perform balancing on the battery cell selected as an object to be balanced. Accordingly, the battery module and the battery pack, which include the battery cell, may be safely managed.

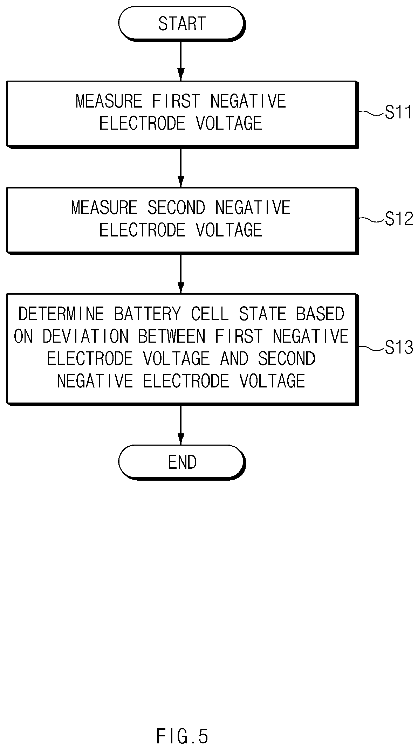

FIG. 5 is a flowchart illustrating a battery management method according to a first embodiment of the present invention.

In an operation S11, a measuring part (e.g., the measuring part 121 in FIG. 4) may measure a voltage (e.g., the first voltage) of a first negative electrode (e.g., the first negative electrode 102 in FIG. 2) of a battery cell (e.g., the battery cell 100 in FIG. 2) while charging the battery cell. The first negative electrode voltage may correspond to a difference between potential of a first negative electrode of the battery cell and reference potential (e.g., 0 V).

As the battery cell is charged, the first negative electrode voltage of the battery cell may be decreased due to an electrochemical phenomenon in the battery cell. When the battery cell is continuously charged in a state in which negative electrode potential of the battery cell is low (e.g., 0 V or less), a phenomenon in which the negative electrode is plated with a metal may occur to cause a reduction in lifetime of the battery cell. Accordingly, the present invention may measure the first negative electrode voltage of the battery cell so that the negative electrode potential of the battery cell is greater than the reference potential during charging of the battery cell.

In an operation S12, the measuring part may measure a second negative electrode voltage (or the second voltage) of a reference cell (e.g., the reference cell 200 in FIG. 3) while charging the reference cell. The second negative electrode voltage may correspond to a difference in potential between a reference electrode (e.g., the reference electrode 203 in FIG. 3) and a second negative electrode (e.g., the second negative electrode 202 in FIG. 3) of the reference cell.

In an operation S13, a controller (e.g., the controller 122 in FIG. 4) may calculate a voltage deviation between the first negative electrode voltage of the battery cell and the second negative electrode voltage of the reference cell, correct the first negative electrode voltage based on the calculated voltage deviation, and estimate a state of health (SOH) of each of the battery module and the battery pack, which include the battery cell, based on the corrected first negative electrode voltage.

As another example, the controller may calculate a voltage deviation between the first negative electrode voltage of the battery cell and the second negative electrode voltage of the reference cell, and estimate a state of health (SOH) of each of the battery module and the battery pack, which include the battery cell, based on the calculated voltage deviation.

The controller may predict a degree of degradation, replacement time, lifetime, and the like of the battery cell based on the estimated SOH. In addition, the controller may control charging for the battery pack so that the first negative electrode voltage of the battery cell, which has been measured (or corrected) through the measuring part, is maintained at a fixed level or higher (or greater than the reference potential). Accordingly, the lifetime characteristics of the battery pack may be improved.

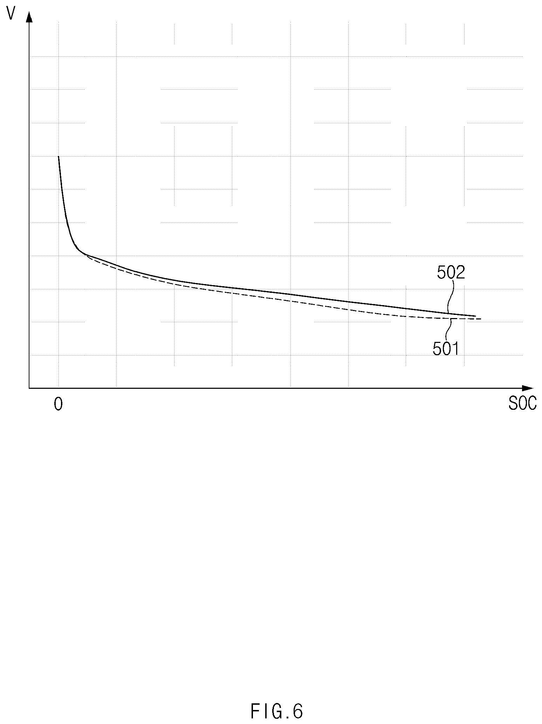

FIG. 6 is a graph illustrating a negative electrode voltage according to a change in state of charge (SOC) of each of the battery cell and the reference cell according to the first embodiment of the present invention. In FIG. 6, a horizontal axis may indicate a SOC (or remaining capacity) of the battery, and a vertical axis may indicate a negative electrode voltage of each of the battery cell and the reference cell. The SOC being 0 may mean that the negative electrode voltage reaches a predetermined upper limit voltage, and the battery cell is in a fully discharged state, and the SOC gradually increasing from 0 may mean that as the negative electrode voltage gradually reaches a predetermined lower limit voltage, the battery cell approaches a fully charged state.

Referring to FIG. 6, a controller (e.g., the controller 122 in FIG. 4) may generate a first negative electrode voltage profile 501 in which as a charged state of the battery cell increases (or an amount of lithium ions stored in the battery cell increases), the first negative electrode voltage gradually decreases. The controller may generate a second negative electrode voltage profile 502 in which as a charged state of the reference cell increases (or an amount of lithium ions stored in the reference cell increases), the second negative electrode voltage gradually decreases. The first negative electrode voltage profile 501 and the second negative electrode voltage profile 501 may be generated through charging experiments on the battery cell and the reference cell. The controller may calculate a voltage deviation between the first negative electrode voltage and the second negative electrode voltage, based on the first negative electrode voltage profile 501 and the second negative electrode voltage profile 502. The controller may estimate a state of health (SOH) of the battery cell based on the calculated voltage deviation.

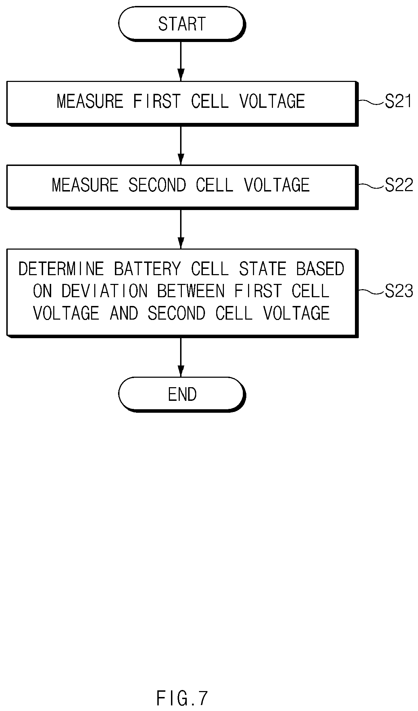

FIG. 7 is a flowchart illustrating a battery management method according to a second embodiment of the present invention.

In an operation S21, a measuring part (e.g., the measuring part 121 in FIG. 4) may measure a first cell voltage (e.g., the first voltage) of a battery cell (e.g., the battery cell 100 in FIG. 2) while charging the battery cell. The first cell voltage may be a voltage corresponding to a difference in potential between a first positive electrode (e.g., the first positive electrode 101 in FIG. 2) and a first negative electrode (e.g., the first negative electrode 102 in FIG. 2) of the battery cell.

In an operation S22, a measuring part may measure a second cell voltage (or the second voltage) of a reference cell (e.g., the reference cell 200 in FIG. 3) while charging the reference cell. The second cell voltage may be a voltage corresponding to a difference between a second positive electrode voltage and a second negative electrode voltage of the reference cell. The second positive electrode voltage may be a voltage corresponding to a difference in potential between a reference electrode (e.g., the reference electrode 203 in FIG. 3) and a second positive electrode (e.g., the second positive electrode 201 in FIG. 3) of the reference cell. The second negative electrode voltage may be a voltage corresponding to a difference in potential between the reference electrode of the reference cell and a second negative electrode (e.g., the second negative electrode 202 in FIG. 3).

In an operation S23, a controller (e.g., the controller 122 in FIG. 4) may calculate a voltage deviation between the first cell voltage of the battery cell and the second cell voltage of the reference cell, correct the first cell voltage based on the calculated voltage deviation, and estimate a state of health (SOH) of each of the battery module and the battery pack, which include the battery cell, based on the corrected first cell voltage.

As another example, the controller may calculate a voltage deviation between the first cell voltage of the battery cell and the second cell voltage of the reference cell, and estimate a state of health (SOH) of each of the battery module and the battery pack, which include the battery cell, based on the calculated voltage deviation.

The controller 122 may predict a degree of degradation, replacement time, lifetime, and the like of the battery cell based on the estimated SOH.

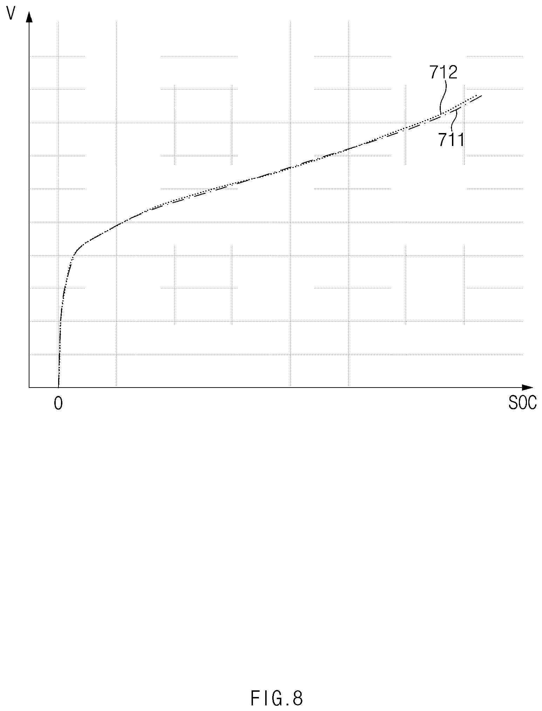

FIG. 8 is a graph illustrating a negative electrode voltage according to a change in state of charge (SOC) of each of a battery cell and a reference cell according to the second embodiment of the present invention. In FIG. 8, a horizontal axis may indicate a SOC (or remaining capacity) of the battery, and a vertical axis may indicate a cell voltage of each of the battery cell and the reference cell.

Referring to FIG. 8, a controller (e.g., the controller 122 in FIG. 4) may generate a first cell voltage profile 711 in which as a charged state of the battery cell increases (or an amount of lithium ions stored in the battery cell increases), the first cell voltage gradually increases. The controller may generate a second cell voltage profile 712 in which as a charged state of the reference cell increases (or an amount of lithium ions stored in the reference cell increases), the second cell voltage gradually increases. The first cell voltage profile 711 and the second cell voltage profile 712 may be generated through charging experiments on the battery cell and the reference cell. The controller may calculate a voltage deviation between the first cell voltage and the second cell voltage, based on the first cell voltage profile 711 and the second cell voltage profile 712. The controller may accurately measure a state of health (SOH) of the battery cell based on the calculated voltage deviation.

The foregoing battery management system and battery management method are not limited to the embodiments described with reference to the drawings, respectively, and the respective structures described in the drawings may be applied in combination with each other. The battery management system according to the present invention may be employed in combination with the management method described with reference to FIG. 5, or with the management method described with reference to FIG. 7. In addition, the battery cell and the reference cell according to the present invention are described with examples of pouch type structures, but are not limited thereto. The battery cell and the reference cell may be applied to cylindrical type or prismatic type structures.

The foregoing battery pack may be applied to various devices. The battery pack may be applied to transport means such as electric bikes, electric vehicles, or hybrid vehicles. However, the battery pack is not limited thereto, and may be applicable to various devices that may use a battery pack.

The invention is defined by the appended claims.

### [Description of the Symbols]

101, 201: Positive electrode
102, 202: Negative electrode
110: Battery pack
120: Battery management system
121: Measuring part
122: Controller
123: Storage part
130: Battery module
200: Reference cell
203: Reference electrode

## Claims

1. A battery pack (110) comprising:
a battery module (130) comprising a battery cell (100) provided in plurality;
at least one reference cell (200) comprising more electrodes than the battery cell (100);
a battery management system (120) configured to control the battery cell and the reference cell (200),
wherein the battery management system (120) is configured to:
measure a first voltage of the battery cell (100);
measure a second voltage of the reference cell (200); and
determine a state of the battery module (130) based on a deviation between the first voltage and the second voltage,
wherein each of the plurality of battery cells (100) comprises a first negative electrode (102) and a first positive electrode (101), and
the reference cell (200) comprises a second negative electrode (202), a second positive electrode (201), and a reference electrode (203),
**characterized by** that
the first voltage is a first negative electrode voltage of the battery cell (100), and
the second voltage is a second negative electrode voltage corresponding to a difference in potential between the reference electrode (203) and the second negative electrode (202) of the reference cell (200).

2. The battery pack (110) of claim 1, wherein the battery management system (120) is configured to:
measure the first negative electrode voltage while charging the battery cell (100); and
measure the second negative electrode voltage while charging the reference cell (200).

3. The battery pack (110) of claim 1, wherein the first voltage is a first cell voltage corresponding to a difference in potential between the first positive electrode (101) and the first negative electrode (102), and
the second voltage is a second cell voltage corresponding to a difference between a second positive electrode voltage and a second negative electrode voltage,
wherein the second positive electrode voltage corresponds to a difference in potential between the reference electrode (203) and the second positive electrode (201), and
the second negative electrode voltage corresponds to a difference in potential between the reference electrode (203) and the second negative electrode (202).

4. The battery pack (110) of claim 3, wherein the battery management system (120) is configured to:
measure the first cell voltage while charging the battery cell (100); and
measure the second cell voltage while charging the reference cell (200).

5. The battery pack (110) of claim 1, wherein the battery management system (120) is configured to:
estimate a state of health (SOH) of the battery module (130) based on a deviation between the first voltage and the second voltage; and
determine a state of each of the plurality of battery cells (100) based on the estimated SOH.

6. The battery pack (110) of claim 1, wherein the battery management system (120) is configured to:
correct the first voltage based on a deviation between the first voltage and the second voltage;
estimate a state of health (SOH) of the battery module (130) based on the corrected first voltage; and
determine a state of each of the plurality of battery cells (100) based on the estimated SOH.

7. A battery management system (120) comprising:
a measuring part (121) configured to measure a first voltage of a battery cell (100), which is provided in plurality and comprised in a battery module (130), and measure a second voltage of at least one reference cell (200) which comprises more electrodes than the battery cell (100); and
a controller (122) configured to determine a state of each of the plurality of battery cells (100) based on a deviation between the first voltage and the second voltage,
wherein each of the plurality of battery cells (100) comprises a first negative electrode (102) and a first positive electrode (101), and
the reference cell (200) comprises a second negative electrode (202), a second positive electrode (201), and a reference electrode (203),
**characterized by** that
the first voltage is a first negative electrode voltage of the battery cell (100), and
the second voltage is a second negative electrode voltage corresponding to a difference in potential between the reference electrode (203) and the second negative electrode (202) of the reference cell (200).

8. The battery management system (120) of claim 7, wherein the measuring part (121) is configured to:
measure the first voltage while charging the battery cell (100) comprising a first negative electrode (102) and a first positive electrode (101); and
measure the second voltage while charging the reference cell (200) comprising a second negative electrode (202), a second positive electrode (201), and a reference electrode (203).

9. A battery management method comprising:
measuring a first voltage of a battery cell (100) that is provided in plurality and comprised in a battery module (130);
measuring a second voltage of at least one reference cell (200) that comprises more electrodes than the battery cell; and
determining a state of each of the plurality of battery cells based on a deviation between the first voltage and the second voltage,
wherein each of the plurality of battery cells (100) comprises a first negative electrode (102) and a first positive electrode (101), and
the reference cell (200) comprises a second negative electrode (202), a second positive electrode (201), and a reference electrode (203),
**characterized by** that
the first voltage is a first negative electrode voltage of the battery cell (100), and
the second voltage is a second negative electrode voltage corresponding to a difference in potential between the reference electrode (203) and the second negative electrode (202) of the reference cell (200).

## Patentansprüche

1. Batteriepack (110), umfassend:
ein Batteriemodul (130), das eine in einer Vielzahl bereitgestellte Batteriezelle (100) umfasst;
mindestens eine Referenzzelle (200), die mehr Elektroden als die Batteriezelle (100) umfasst;
ein Batteriemanagementsystem (120), das so konfiguriert ist, dass es die Batteriezelle und die Referenzzelle (200) steuert,
wobei das Batteriemanagementsystem (120) konfiguriert ist zum:
Messen einer ersten Spannung der Batteriezelle (100);
Messen einer zweiten Spannung der Referenzzelle (200); und
Bestimmen eines Zustands des Batteriemoduls (130) basierend auf einer Abweichung zwischen der ersten Spannung und der zweiten Spannung,
wobei jede der Vielzahl von Batteriezellen (100) eine erste negative Elektrode (102) und eine erste positive Elektrode (101) umfasst, und
die Referenzzelle (200) eine zweite negative Elektrode (202), eine zweite positive Elektrode (201) und eine Referenzelektrode (203) umfasst,
**dadurch gekennzeichnet, dass** die erste Spannung eine erste negative Elektrodenspannung der Batteriezelle (100) ist, und
die zweite Spannung eine zweite negative Elektrodenspannung ist, die einer Potenzialdifferenz zwischen der Referenzelektrode (203) und der zweiten negativen Elektrode (202) der Referenzzelle (200) entspricht.

2. Batteriepack (110) nach Anspruch 1, wobei das Batteriemanagementsystem (120) konfiguriert ist zum:
Messen der ersten negativen Elektrodenspannung während des Ladens der Batteriezelle (100); und
Messen der zweiten negativen Elektrodenspannung während des Ladens der Referenzzelle (200).

3. Batteriepack (110) nach Anspruch 1, wobei die erste Spannung eine erste Zellenspannung ist, die einer Potenzialdifferenz zwischen der ersten positiven Elektrode (101) und der ersten negativen Elektrode (102) entspricht, und
die zweite Spannung eine zweite Zellenspannung ist, die einer Differenz zwischen einer zweiten positiven Elektrodenspannung und einer zweiten negativen Elektrodenspannung entspricht,
wobei die zweite positive Elektrodenspannung einer Potenzialdifferenz zwischen der Referenzelektrode (203) und der zweiten positiven Elektrode (201) entspricht, und
die zweite negative Elektrodenspannung einer Potenzialdifferenz zwischen der Referenzelektrode (203) und der zweiten negativen Elektrode (202) entspricht.

4. Batteriepack (110) nach Anspruch 3, wobei das Batteriemanagementsystem (120) konfiguriert ist zum:
Messen der ersten Zellenspannung während des Ladens der Batteriezelle (100); und
Messen der zweiten Zellenspannung während des Ladens der Referenzzelle (200).

5. Batteriepack (110) nach Anspruch 1, wobei das Batteriemanagementsystem (120) konfiguriert ist zum:
Schätzen eines Alterungszustands (SOH) des Batteriemoduls (130) basierend auf einer Abweichung zwischen der ersten Spannung und der zweiten Spannung; und
Bestimmen eines Zustands jeder der Vielzahl von Batteriezellen (100) basierend auf dem geschätzten SOH.

6. Batteriepack (110) nach Anspruch 1, wobei das Batteriemanagementsystem (120) konfiguriert ist zum:
Korrigieren der ersten Spannung basierend auf einer Abweichung zwischen der ersten Spannung und der zweiten Spannung;
Schätzen eines Alterungszustands (SOH) des Batteriemoduls (130) basierend auf der korrigierten ersten Spannung; und
Bestimmen eines Zustands jeder der Vielzahl von Batteriezellen (100) basierend auf dem geschätzten SOH.

7. Batteriemanagementsystem (120), umfassend:
einen Messteil (121), der so konfiguriert ist, dass er eine erste Spannung einer Batteriezelle (100) misst, die in einer Vielzahl bereitgestellt und in einem Batteriemodul (130) enthalten ist, und eine zweite Spannung mindestens einer Referenzzelle (200) misst, die mehr Elektroden als die Batteriezelle (100) umfasst; und
eine Steuerung (122), die so konfiguriert ist, dass sie einen Zustand jeder der Vielzahl von Batteriezellen (100) basierend auf einer Abweichung zwischen der ersten Spannung und der zweiten Spannung bestimmt,
wobei jede der Vielzahl von Batteriezellen (100) eine erste negative Elektrode (102) und eine erste positive Elektrode (101) umfasst, und
die Referenzzelle (200) eine zweite negative Elektrode (202), eine zweite positive Elektrode (201) und eine Referenzelektrode (203) umfasst,
**dadurch gekennzeichnet, dass** die erste Spannung eine erste negative Elektrodenspannung der Batteriezelle (100) ist, und
die zweite Spannung eine zweite negative Elektrodenspannung ist, die einer Potenzialdifferenz zwischen der Referenzelektrode (203) und der zweiten negativen Elektrode (202) der Referenzzelle (200) entspricht.

8. Batteriemanagementsystem (120) nach Anspruch 7, wobei der Messteil (121) konfiguriert ist zum:
Messen der ersten Spannung während des Ladens der Batteriezelle (100), die eine erste negative Elektrode (102) und eine erste positive Elektrode (101) umfasst; und
Messen der zweiten Spannung während des Ladens der Referenzzelle (200), die eine zweite negative Elektrode (202), eine zweite positive Elektrode (201) und eine Referenzelektrode (203) umfasst.

9. Batteriemanagementverfahren, umfassend:
Messen einer ersten Spannung einer Batteriezelle (100), die in einer Vielzahl bereitgestellt und in einem Batteriemodul (130) enthalten ist;
Messen einer zweiten Spannung mindestens einer Referenzzelle (200), die mehr Elektroden als die Batteriezelle umfasst; und
Bestimmen eines Zustands jeder der Vielzahl von Batteriezellen basierend auf einer Abweichung zwischen der ersten Spannung und der zweiten Spannung,
wobei jede der Vielzahl von Batteriezellen (100) eine erste negative Elektrode (102) und eine erste positive Elektrode (101) umfasst, und
die Referenzzelle (200) eine zweite negative Elektrode (202), eine zweite positive Elektrode (201) und eine Referenzelektrode (203) umfasst,
**dadurch gekennzeichnet, dass** die erste Spannung eine erste negative Elektrodenspannung der Batteriezelle (100) ist, und
die zweite Spannung eine zweite negative Elektrodenspannung ist, die einer Potenzialdifferenz zwischen der Referenzelektrode (203) und der zweiten negativen Elektrode (202) der Referenzzelle (200) entspricht.

## Revendications

1. Bloc-batterie (110) comprenant :
un module de batterie (130) comprenant une cellule de batterie (100) fournie en pluralité ;
au moins une cellule de référence (200) comprenant plus d'électrodes que la cellule de batterie (100) ;
un système de gestion de batterie (120) configuré pour commander la cellule de batterie et la cellule de référence (200),
dans lequel le système de gestion de batterie (120) est configuré pour :
mesurer une première tension de la cellule de batterie (100) ;
mesurer une deuxième tension de la cellule de référence (200) ; et
déterminer un état du module de batterie (130) sur la base d'un écart entre la première tension et la deuxième tension,
dans lequel chacune de la pluralité de cellules de batterie (100) comprend une première électrode négative (102) et une première électrode positive (101), et
la cellule de référence (200) comprend une deuxième électrode négative (202), une deuxième électrode positive (201) et une électrode de référence (203),
**caractérisé en ce que** la première tension est une première tension d'électrode négative de la cellule de batterie (100), et
la deuxième tension est une deuxième tension d'électrode négative correspondant à une différence de potentiel entre l'électrode de référence (203) et la deuxième électrode négative (202) de la cellule de référence (200).

2. Bloc-batterie (110) selon la revendication 1, dans lequel le système de gestion de batterie (120) est configuré pour :
mesurer la première tension d'électrode négative pendant la charge de la cellule de batterie (100) ; et
mesurer la deuxième tension d'électrode négative pendant la charge de la cellule de référence (200).

3. Bloc-batterie (110) selon la revendication 1, dans lequel la première tension est une première tension de cellule correspondant à une différence de potentiel entre la première électrode positive (101) et la première électrode négative (102), et
la deuxième tension est une deuxième tension de cellule correspondant à une différence entre une deuxième tension d'électrode positive et une deuxième tension d'électrode négative,
dans lequel la deuxième tension d'électrode positive correspond à une différence de potentiel entre l'électrode de référence (203) et la deuxième électrode positive (201), et
la deuxième tension d'électrode négative correspond à une différence de potentiel entre l'électrode de référence (203) et la deuxième électrode négative (202).

4. Bloc-batterie (110) selon la revendication 3, dans lequel le système de gestion de batterie (120) est configuré pour :
mesurer la première tension de cellule pendant la charge de la cellule de batterie (100) ; et
mesurer la deuxième tension de cellule pendant la charge de la cellule de référence (200).

5. Bloc-batterie (110) selon la revendication 1, dans lequel le système de gestion de batterie (120) est configuré pour :
estimer un état de santé (SOH) du module de batterie (130) sur la base d'un écart entre la première tension et la deuxième tension ; et
déterminer un état de chacune de la pluralité de cellules de batterie (100) sur la base du SOH estimé.

6. Bloc-batterie (110) selon la revendication 1, dans lequel le système de gestion de batterie (120) est configuré pour :
corriger la première tension sur la base d'un écart entre la première tension et la deuxième tension ;
estimer un état de santé (SOH) du module de batterie (130) sur la base de la première tension corrigée ; et
déterminer un état de chacune de la pluralité de cellules de batterie (100) sur la base du SOH estimé.

7. Système de gestion de batterie (120) comprenant :
une partie de mesure (121) configurée pour mesurer une première tension d'une cellule de batterie (100), qui est fournie en pluralité et comprise dans un module de batterie (130), et mesurer une deuxième tension d'au moins une cellule de référence (200) qui comprend plus d'électrodes que la cellule de batterie (100) ; et
un contrôleur (122) configuré pour déterminer un état de chacune de la pluralité de cellules de batterie (100) sur la base d'un écart entre la première tension et la deuxième tension,
dans lequel chacune de la pluralité de cellules de batterie (100) comprend une première électrode négative (102) et une première électrode positive (101), et
la cellule de référence (200) comprend une deuxième électrode négative (202), une deuxième électrode positive (201) et une électrode de référence (203),
**caractérisé en ce que** la première tension est une première tension d'électrode négative de la cellule de batterie (100), et
la deuxième tension est une deuxième tension d'électrode négative correspondant à une différence de potentiel entre l'électrode de référence (203) et la deuxième électrode négative (202) de la cellule de référence (200).

8. Système de gestion de batterie (120) selon la revendication 7, dans lequel la partie de mesure (121) est configurée pour :
mesurer la première tension pendant la charge de la cellule de batterie (100) comprenant une première électrode négative (102) et une première électrode positive (101) ; et
mesurer la deuxième tension pendant la charge de la cellule de référence (200) comprenant une deuxième électrode négative (202), une deuxième électrode positive (201) et une électrode de référence (203).

9. Procédé de gestion de batterie comprenant :
la mesure d'une première tension d'une cellule de batterie (100) qui est fournie en pluralité et comprise dans un module de batterie (130) ;
la mesure d'une deuxième tension d'au moins une cellule de référence (200) qui comprend plus d'électrodes que la cellule de batterie ; et
la détermination d'un état de chacune de la pluralité de cellules de batterie sur la base d'un écart entre la première tension et la deuxième tension,
dans lequel chacune de la pluralité de cellules de batterie (100) comprend une première électrode négative (102) et une première électrode positive (101), et
la cellule de référence (200) comprend une deuxième électrode négative (202), une deuxième électrode positive (201) et une électrode de référence (203),
**caractérisé en ce que** la première tension est une première tension d'électrode négative de la cellule de batterie (100), et
la deuxième tension est une deuxième tension d'électrode négative correspondant à une différence de potentiel entre l'électrode de référence (203) et la deuxième électrode négative (202) de la cellule de référence (200).
